# EUROPEAN PATENT APPLICATION

(11) **EP 4 246 559 A1**
(43) Date of publication of application: **20.09.2023**
(21) Application number: 21891906.6
(22) Date of filing: 10.11.2021
(51) Int. Cl.: H01L 21/52

(54) **MANUFACTURING METHOD FOR COMPLEX AND MANUFACTURING METHOD FOR SEMICONDUCTOR DEVICE**

(30) Priority: 12.11.2020 US 202063112835 P
(71) Applicant: Panasonic Intellectual Property Management Co., Ltd., Osaka-shi, Osaka 540-6207 (JP)
(72) Inventor: KONDA, Tetsushi, Osaka-shi, Osaka 540-6207 (JP); KITAMURA, Kenji, Osaka-shi, Osaka 540-6207 (JP); HAGIWARA, Takahito, Osaka-shi, Osaka 540-6207 (JP); MATSUBAYASHI, Ryo, Osaka-shi, Osaka 540-6207 (JP); UMEDA, Hidekazu, Osaka-shi, Osaka 540-6207 (JP)
(74) Representative: Appelt, Christian W.
(86) International application number: PCT/JP2021/041354
(87) International publication number: WO 2022/102660

(57) **Abstract**

The problem to be overcome by the present disclosure is to provide a method for manufacturing a composite structure, including a base member, a bonding layer, and an element to be bonded, by sintering a metal paste between the base member and the element to be bonded and thereby forming the bonding layer between them, while increasing the efficiency of forming the bonding layer and reducing the chances of creating voids in the bonding layer. The manufacturing method includes: an application step including providing a bonding material on the base member by applying the metal paste onto the base member; a preheating step including heating the bonding material before the element to be bonded is stacked on the bonding material and thereby drying the bonding material until a percentage of an organic component in the bonding material becomes equal to or greater than 3% by mass and equal to or less than 8% by mass with respect to the bonding material; a mounting step including stacking the element to be bonded onto the bonding material and heating the bonding material to form a multi-layer stack; and a sintering step including sintering the bonding material by heating the multi-layer stack in a heating furnace and thereby forming the bonding layer.

## Description

### Technical Field

The present disclosure generally relates to a method for manufacturing a composite structure and a method for fabricating a semiconductor device. More particularly, the present disclosure relates to a method for manufacturing a composite structure including sintering a metal paste and a method for fabricating a semiconductor device including such a method for manufacturing a composite structure.

### Background Art

The process step of mounting a semiconductor chip on a board sometimes includes forming a bonding layer by sintering a metal paste interposed between the semiconductor chip and the board and thereby fixing the semiconductor chip onto the board via this bonding layer. Such a process step is generally called "die bonding."

For example, Patent Literature 1 discloses a method for bonding a semiconductor device including bonding a semiconductor element onto a board, on which a conductor pattern has been formed, using a metallic particle paste including metallic particles.

### Citation List

### Patent Literature

Patent Literature 1: JP 2012-9703 A

### Summary of Invention

The problem to be overcome by the present disclosure is to provide a method for manufacturing a composite structure, including a base member, a bonding layer, and an element to be bonded, by sintering a metal paste between the base member and the element to be bonded and thereby forming the bonding layer between them, while increasing the efficiency of forming the bonding layer and reducing the chances of creating voids in the bonding layer and also provide a method for fabricating a semiconductor device including such a method for manufacturing a composite structure.

A method for manufacturing a composite structure according to an aspect of the present disclosure is a method for manufacturing a composite structure including: a base member; an element to be bonded; and a bonding layer interposed between the base member and the element to be bonded. The bonding layer is a sintered compact of a metal paste. The metal paste contains a metal powder and an organic component. The method includes: an application step including providing a bonding material on the base member by applying the metal paste onto the base member; a preheating step including heating the bonding material before the element to be bonded is stacked on the bonding material and thereby drying the bonding material until a percentage of the organic component in the bonding material becomes equal to or greater than 3% by mass and equal to or less than 8% by mass with respect to the bonding material; a mounting step including stacking the element to be bonded onto the bonding material and heating the bonding material, on which the element to be bonded is stacked, to form a multi-layer stack including the base member, the bonding material, and the element to be bonded; and a sintering step including sintering the bonding material by heating the multi-layer stack in a heating furnace and thereby forming the bonding layer.

A method for fabricating a semiconductor device according to another aspect of the present disclosure includes the method for manufacturing the composite structure described above.

### Brief Description of Drawings

FIG. 1A is a cross-sectional view of a base member and a bonding material according to an exemplary embodiment of the present disclosure;
FIG. 1B is a cross-sectional view of a multi-layer stack according to the exemplary embodiment of the present disclosure;
FIG. 1C is a cross-sectional view of a composite structure according to the exemplary embodiment of the present disclosure;
FIG. 1D is a cross-sectional view of a semiconductor device according to the exemplary embodiment of the present disclosure;
FIG. 2 is a graph showing results of TG-DTA measurements conducted on the bonding material subjected to a preheating step with respect to Examples 1-3; and
FIG. 3 is a graph showing how a heating temperature varied with time in a sintering step in Example 1.

### Description of Embodiments

First, it will be described generally how the present inventors conceived the concept of the present disclosure. The process step of mounting a semiconductor chip onto a board sometimes includes forming a bonding layer by sintering a metal paste interposed between the semiconductor chip and the board and thereby fixing the semiconductor chip onto the board via this bonding layer. Such a process step is generally called "die bonding." The present inventors carried out research and development to make the following discovery. Specifically, a metal paste contains an organic component such as a solvent. However, as for a semiconductor chip of a large size, it is difficult to remove the organic component from the metal paste while the metal paste is being sintered. If the organic component vaporizes while being left in the metal paste, then voids may be created in the bonding layer. As the temperature of the metal paste is increased steeply to sinter the metal paste, voids will be created at a significantly high rate, thus increasing the chances of causing cracks in the bonding layer. To prevent such cracks from being caused, the chances of creating voids need to be reduced by decreasing the temperature increase rate in the heating temperature for heating the metal paste and lowering the highest heating temperature while the metal paste is being sintered. In that case, however, it takes a longer time to have the metal paste sintered, thus causing a decrease in production efficiency.

To overcome such a problem, the present inventors carried out research and development to provide, when manufacturing a composite structure including a base member, a bonding layer, and an element to be bonded by sintering a metal paste between the base member and the element to be bonded and thereby forming a bonding layer between them, a technique for increasing the efficiency of forming the bonding layer while reducing the chances of creating voids in the bonding layer, thus conceiving the concept of the present disclosure.

Note that although the present inventors conceived the concept of the present disclosure in this procedure, this is only an exemplary procedure and should not be construed as limiting the applicability of the present disclosure. Specifically, the base member according to the present disclosure does not have to be the wiring board described above and the element to be bonded does not have to be the semiconductor chip described above.

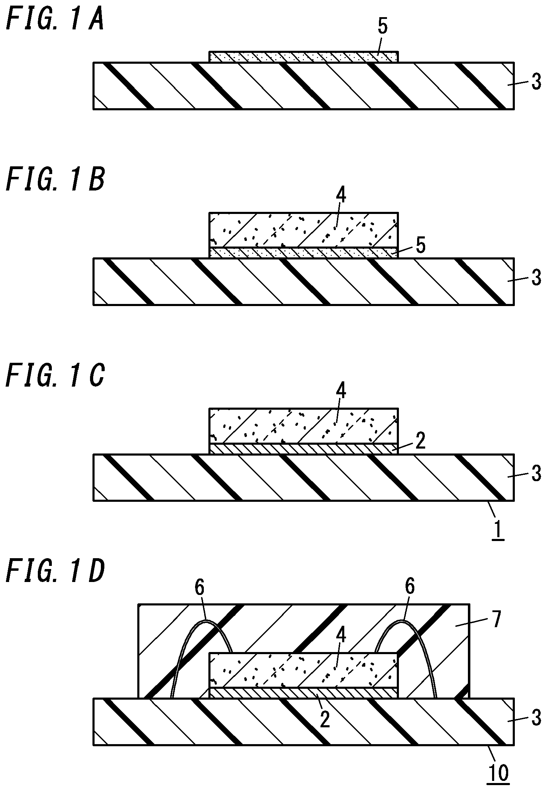

Next, an exemplary embodiment of the present disclosure will be described with reference to FIGS. 1A-1D. Note that the embodiment to be described below is not the only embodiment of the present disclosure. In other words, the embodiment to be described below is only an exemplary one of various embodiments of the present disclosure and should not be construed as limiting. Rather, the exemplary embodiment may be readily modified in various manners depending on a design choice or any other factor without departing from the scope of the present disclosure.

In this embodiment, a composite structure 1 includes a base member 3, an element 4 to be bonded, and a bonding layer 2 interposed between the base member 3 and the element 4 to be bonded (refer to FIG. 1C). The bonding layer 2 is a sintered compact of a metal paste containing a metal powder and an organic component. More specifically, the bonding layer 2 is a sintered compact of a bonding material 5 of the metal paste.

A method for manufacturing a composite structure 1 according to this embodiment includes an application step, a preheating step, a mounting step, and a sintering step. The application step includes providing a bonding material 5 on the base member 3 by applying the metal paste onto the base member 3 (refer to FIG. 1A). The preheating step includes heating the bonding material 5 before the element 4 to be bonded is stacked on the bonding material 5 and thereby drying the bonding material 5 until the percentage of the organic component in the bonding material 5 becomes equal to or greater than 3% by mass and equal to or less than 8% by mass with respect to the bonding material 5. The mounting step includes stacking the element 4 to be bonded onto the bonding material 5 and heating the bonding material 5, on which the element 4 to be bonded is stacked, to form a multi-layer stack including the base member 3, the bonding material 5, and the element 4 to be bonded (refer to FIG. 1B). The sintering step includes sintering the bonding material 5 by heating the multi-layer stack in a heating furnace and thereby forming the bonding layer 2 (refer to FIG. 1C).

In this embodiment, the percentage of the organic component in the bonding material 5 in the preheating step is equal to or greater than 3% by mass, thus allowing the bonding material 5 to have moderate flexibility and reducing the chances of leaving a gap between the bonding material 5 and the element 4 to be bonded in the mounting step. In addition, the percentage of the organic component in the bonding material 5 in the preheating step is equal to or less than 8% by mass. Thus, even if the organic component vaporizes from the bonding material 5 in the sintering step, the organic component vaporized is unlikely to be left in the bonding material 5. For these reasons, the chances of creating voids in the sintered compact may be reduced. This may reduce, even if the bonding material 5 is heated too rapidly while the bonding layer 2 is being formed by sintering the bonding material 5 in the sintering step, the chances of doing damage to the bonding layer 2 due to expansion of the voids. Thus, the sintering step may be done in a shorter time.

Consequently, this embodiment enables forming the bonding layer 2 significantly more efficiently while reducing the chances of creating voids in the bonding layer 2.

Next, this embodiment will be described in further detail.

The base member 3 may be, for example, a wiring board. More specifically, the base member 3 may be a motherboard, a package board, or an interposer board.

The element 4 to be bonded may be, for example, a semiconductor chip. The semiconductor chip may be, but does not have to be, a bare chip (die).

The metal paste contains a metal powder and an organic component as described above.

The metal powder may be, but does not have to be, silver powder. The metal powder may have a mean particle size equal to or greater than 50 nm and equal to or less than 500 nm, for example. Note that the mean particle size of the metal powder is a particle size calculated based on the specific surface area of the metal powder as measured by the BET method (i.e., a BET size).

The metal paste preferably further contains a melt sat which is a salt of a metal corresponding to the metal powder in the metal paste. For example, if the metal paste contains silver powder, then the metal paste preferably further contains silver salt. The silver salt may contain, for example, silver acetate. Letting the metal paste contain a metal salt reduces the chances of producing air gaps in the bonding layer 2 that is a sintered compact of the metal paste, which may increase the reliability of the bonding layer 2. If the metal paste contains a metal salt, then the percentage of the metal derived from the metal salt is preferably equal to or greater than 0.5% by mass and equal to or less than 5% by mass with respect to the metal particle.

Any organic component may be used without limitation as long as the organic component allows, when mixed with a metal powder, the metal powder to be prepared into a paste. The organic component contains an organic solvent which is liquid at 25°C, for example. The organic component preferably has a boiling point equal to or higher than 150°C and equal to or lower than 280°C. This allows the content of the organic component in the bonding material 5 to be adjusted easily through the preheating step.

It is also preferable that the organic component contain a compound having an amino group. Turning a metal salt into a complex salt using such a compound having an amino group allows a metal such as silver to be dispersed in the metal paste at a molecular level, thus allowing the sintered compact to have a uniform dense structure.

It is also preferable that the organic component contain a compound having a hydroxyl group. In that case, letting the metal paste contain a metal salt, in particular, allows the compound having the hydroxyl group to reduce the metal salt while the metal paste is being sintered. As a result, the electrical conductivity of the bonding layer 2 may be increased.

It is also preferable that the organic component contain a compound having both an amino group and a hydroxyl group.

If the organic component contains a compound having a hydroxyl group, then the organic component contains at least one selected from the group consisting of, for example, 2-ethyl-1,3-hexanediol (having a boiling point of 243°C), terpineol (having a boiling point of 217°C), ethylene glycol (having a boiling point of 197°C), propanediol (having a boiling point of 188°C), isobornyl cyclohexanol (having a boiling point of 300°C), and 2,3-butanediol (having a boiling point of 182°C). If the organic component contains a compound having an amino group, then the organic component contains at least one selected from the group consisting of, for example, 2-ethylhexylamine (having a boiling point of 170°C), heptylamine (having a boiling point of 157°C), octylamine (having a boiling point of 176°C), nonylamine (having a boiling point of 202°C), aminodecane (having a boiling point of 217°C), and dodecylamine (having a boiling point of 250°C). If the organic component contains a compound having both an amino group and a hydroxyl group, then the organic component contains at least one selected from the group consisting of 3-amino-1-propanol (having a boiling point of 188°C) and 1-amino-2-propanol (having a boiling point of 160°C).

The content of the organic component in the metal paste applied in the application step may be adjusted appropriately such that the metal paste may be applied and molded. The percentage of the organic component is preferably equal to or greater than 8% by mass and equal to or less than 15% by mass with respect to metallic particles. This allows the metal paste to have moderate moldability.

Next, respective steps included in the method for manufacturing the composite structure 1 will be described one by one.

The application step includes providing the bonding material 5 on the base member 3 by applying the metal paste onto the base member 3 (refer to FIG. 1A). The metal paste may be, but does not have to be, applied by screen printing.

The preheating step includes heating the bonding material 5 before the element 4 to be bonded is stacked on the bonding material 5 and thereby drying the bonding material 5 until the percentage of the organic component in the bonding material 5 becomes equal to or greater than 3% by mass and equal to or less than 8% by mass with respect to the bonding material 5, as described above.

The preheating step preferably includes heating the bonding material 5 by heating a surface, arranged in contact with the base member 3, of the bonding material 5. This may reduce the chances of causing non-uniformity in the distribution of the organic component left in the bonding material 5 after the bonding material 5 has been heated in the preheating step. That is to say, this may reduce the chances of making the content of the organic component significantly lower in a surface region of the bonding material 5 than in an inner region thereof. This allows the surface of the bonding material 5 to have moderate flexibility and thereby makes it easier for the element 4 to be bonded to adhere closely to the bonding material 5 when the element 4 to be bonded is stacked on the bonding material 5. As a result, the bond strength between the element 4 to be bonded and the bonding layer 2 formed out of the bonding material 5 may be increased.

To heat the surface, arranged in contact with the base member 3, of the bonding material 5, the base member 3 may be heated by being disposed on a hot plate, thereby heating the bonding material 5 through the base member 3.

The preheating step preferably includes heating the bonding material 5 to a heating temperature equal to or higher than 70°C and equal to or lower than 145°C. Setting the heating temperature at a temperature equal to or higher than 70°C allows the organic component to be vaporized efficiently from the bonding material 5. Setting the heating temperature at a temperature equal to or lower than 145°C reduces the rapid vaporization of the organic component, thus further reducing the chances of causing non-uniformity in the distribution of the organic component in the bonding material 5. The heating temperature is more preferably equal to or higher than 75°C and is even more preferably equal to or higher than 80°C. Meanwhile, the heating temperature is more preferably equal to or lower than 110°C and is even more preferably equal to or lower than 100°C. Note that this heating temperature is the temperature of the bonding material 5 being heated. If the surface, arranged in contact with the base member 3, of the bonding material 5 is heated, then the heating temperature is the temperature of that surface. On the other hand, if the surface is heated by heating the base member 3, then the heating temperature is the temperature of the base member 3.

Also, the heating duration for heating the bonding material 5 in the preheating step may be set appropriately such that the content of the organic solvent in the bonding material 5 is adjusted appropriately. The heating duration is preferably equal to or longer than 1 minute and equal to or shorter than 30 minutes. This allows the content of the organic solvent in the bonding material 5 to be adjusted appropriately. The heating duration is more preferably equal to or longer than 2 minutes and is even more preferably equal to or longer than 3 minutes. Meanwhile, the heating duration is more preferably equal to or shorter than 20 minutes and even more preferably equal to or shorter than 10 minutes.

Next, the mounting step includes stacking the element 4 to be bonded onto the bonding material 5 and heating the bonding material 5, on which the element 4 to be bonded is stacked, to form a multi-layer stack including the base member 3, the bonding material 5, and the element 4 to be bonded (refer to FIG. 1B).

The mounting step allows the bonding material 5 to be softened by heating the bonding material 5, thus making it easier for the element 4 to be bonded to adhere to the bonding material 5 closely. As a result, the bond strength between the element 4 to be bonded and the bonding layer 2 formed out of the bonding material 5 may be increased. In addition, the organic solvent in the bonding material 5 is further vaporized by heating the bonding material 5, thus further reducing the chances of creating voids in the bonding material 5 and in the bonding layer 2 during the sintering step.

The mounting step preferably includes heating the bonding material 5 to a heating temperature equal to or higher than 70°C and equal to or lower than 145°C. Setting the heating temperature at a temperature equal to or higher than 70°C may increase the bond strength between the bonding layer 2 and the element 4 to be bonded particularly significantly. Setting the heating temperature at a temperature equal to or lower than 145°C may further reduce the chances of causing cracks in the bonding layer 2 and may increase the bond strength between the bonding layer 2 and the element 4 to be bonded particularly significantly. The heating temperature is more preferably equal to or higher than 75°C and is even more preferably equal to or higher than 80°C. Meanwhile, the heating temperature is more preferably equal to or lower than 140°C and is even more preferably equal to or lower than 135°C. Note that the heating temperature in this case herein refers to, for example, the temperature of a member for heating the base member 3 and the element 4 to be bonded while keeping in contact with the base member 3 and the element 4 to be bonded. Specifically, the heating temperature herein refers to, for example, the temperature of a stage and a mounter of a chip mounter for use to mount the element 4 to be bonded onto the base member 3.

Also, the mounting step may include heating the bonding material 5 for a heating duration equal to or longer than 0.5 seconds and equal to or shorter than 3 seconds, for example.

The mounting step preferably includes applying load to the element 4 to be bonded toward the bonding material 5 to apply pressure from the element 4 to be bonded to the bonding material 5 in a state where the element 4 to be bonded is stacked on the bonding material 5. That is to say, pressure is preferably applied from the element 4 to be bonded to the bonding material 5 while the bonding material 5 is being heated. This makes it even easier for the element 4 to be bonded to adhere to the bonding material 5 closely. As a result, the bond strength between the element 4 to be bonded and the bonding layer 2 formed out of the bonding material 5 may be further increased. At this time, a pressure equal to or higher than 0.5 MPa and equal to or lower than 10 MPa is preferably applied from the element 4 to be bonded to the bonding material 5. Setting this pressure at a value equal to or greater than 0.5 MPa makes it particularly easier for the element 4 to be bonded to adhere to the bonding material 5 closely. Meanwhile, setting this pressure at a value equal to or less than 10 MPa may reduce the damage to be done onto a member such as the element 4 to be bonded. This pressure is more preferably equal to or higher than 1 MPa and is even more preferably equal to or higher than 2 MPa. Meanwhile, the pressure is more preferably equal to or lower than 9 MPa and is even more preferably equal to or lower than 8 MPa.

Furthermore, the mounting step may include applying pressure to the bonding material 5 while heating the bonding material 5 for a duration equal to or longer than 0.5 seconds and equal to or shorter than 3 seconds, for example.

Optionally, the mounting step may include applying ultrasonic vibrations to the bonding material 5 while applying load to the element 4 to be bonded toward the bonding material 5. That is to say, ultrasonic vibrations may be applied to the bonding material 5 with the element 4 to be bonded stacked on the bonding material 5, the bonding material 5 heated, and load applied to the element 4 to be bonded toward the bonding material 5. In that case, the ultrasonic vibrations applied facilitate deforming the surface of the bonding material 5 along the surface of the element 4 to be bonded, thus making it easier for the element 4 to be bonded to adhere onto the bonding material 5 more closely. As a result, the bond strength between the element 4 to be bonded and the bonding layer 2 formed out of the bonding material 5 may be further increased. If ultrasonic vibrations need to be applied to the bonding material 5, the ultrasonic vibrations are applied to the bonding material 5 by producing ultrasonic vibrations in at least one of the base member 3 or the element 4 to be bonded, for example.

The ultrasonic vibrations are preferably applied to the bonding material 5 for a duration equal to or longer than 0.5 seconds and equal to or shorter than 3 seconds. Setting this duration at 0.5 seconds or more may increase the bond strength between the bonding layer 2 and the element 4 to be bonded particularly significantly. Setting this duration at 3 seconds or less may reduce the damage to be done onto the element 4 to be bonded and other members due to the ultrasonic vibrations. This duration is more preferably equal to or longer than 1 second. Meanwhile, this duration is more preferably equal to or shorter than 2.5 seconds and is even more preferably equal to or shorter than 2 seconds.

Next, the sintering step includes sintering the bonding material 5 by heating the multi-layer stack in a heating furnace and thereby forming the bonding layer 2 (refer to FIG. 1C).

In this embodiment, the bonding material 5 is heated by heating the multi-layer stack in a heating furnace, thereby sintering the bonding material 5. A furnace used as a reflow furnace, for example, is usable as the heating furnace.

The temperature of heating the multi-layer stack in the heating furnace in the sintering step may be set appropriately so that the bonding material 5 may be sintered sufficiently and that no damage is done to the element 4 to be bonded or the base member 3. The highest heating temperature of the multi-layer stack is preferably equal to or lower than 350°C. This may reduce the chances of the element 4 to be bonded and other members being damaged under the heat. Also, the highest heating temperature of the multi-layer stack is preferably equal to or higher than 300°C and equal to or lower than 350°C. As used herein, the "heating temperature" refers to the temperature of the bonding material 5 in the multi-layer stack heated.

Furthermore, the sintering step may include heating the multi-layer stack for a heating duration equal to or longer than 3 minutes and equal to or shorter than 10 minutes, for example. As used herein, the "heating duration" refers to a duration for which the multi-layer stack is heated in the heating furnace and includes the duration of a cooling step (to be described later). Setting the heating duration at 3 minutes or more enables sintering the bonding material 5 sufficiently through the sintering step. Meanwhile, setting the heating duration at 10 minutes or less enables improving the manufacturing efficiency of the composite structure 1 particularly significantly and reducing the damage to be done to the element 4 to be bonded and other members.

Furthermore, the sintering step may include increasing the heating temperature at a temperature increase rate equal to or higher than 1°C/s and equal to or lower than 7°C/s, for example. This enables shortening the heating duration in the sintering step, thus improving the manufacturing efficiency of the composite structure 1 particularly significantly. In addition, according to this embodiment, even if the temperature increase rate in the sintering step is increased, the chances of creating voids in the bonding layer 2 may still be reduced. Thus, the chances of creating voids in the bonding layer 2 may also be reduced even at a temperature increase rate equal to or higher than 1 second and equal to or lower than 7 seconds.

Specifically, the sintering step may include, for example, a first temperature increasing step, a first heating step that follows the first temperature increasing step, a second temperature increasing step that follows the first heating step, a second heating step that follows the second temperature increasing step, and the cooling step that follows the second heating step. The second heating step includes heating the bonding material 5 within a temperature range including the highest heating temperature. The first heating step includes heating the bonding material 5 within a lower temperature range than in the second heating step. The first temperature increasing step includes increasing the temperature of the bonding material 5 from room temperature to the heating temperature for the first heating step. The second temperature increasing step includes increasing the temperature of the bonding material 5 from the heating temperature for the first heating step to the heating temperature for the second heating step. The cooling step includes cooling the multi-layer stack from the heating temperature for the second heating step.

More specifically, in the sintering step, first, the first temperature increasing step includes increasing the temperature of the bonding material 5 from room temperature to a temperature falling within the range from 100°C to 170°C at a temperature increase rate equal to or higher than 1°C/s and equal to or lower than 7°C/s. Next, the first heating step preferably includes maintaining the temperature of the bonding material 5 within the range from 100°C to 170°C for a duration equal to or longer than 30 seconds and equal to or shorter than 120 seconds. Subsequently, the second temperature increasing step preferably includes increasing the temperature of the bonding material 5 to a temperature falling within the range from 300°C to 350°C at a temperature increase rate equal to or higher than 1°C/s and equal to or lower than 7°C/s. Next, the second heating step preferably includes maintaining the temperature of the bonding material 5 within the range from 300°C to 350°C for a duration equal to or longer than 30 seconds and equal to or shorter than 120 seconds. Finally, the cooling step includes lowering the temperature of the bonding material 5 at a cooling rate equal to or higher than 10°C/s. Note that this heating condition for the sintering step is only an example and should not be construed as limiting.

If the base member 3 of the composite structure 1 is a wiring board and the element 4 to be bonded is a semiconductor chip, then the semiconductor chip may be fixed onto the wiring board via the bonding layer 2. In addition, the bonding layer 2 is a sintered compact of a metal powder, and therefore, has high thermal conductivity. Thus, the bonding layer 2 may transfer the heat generated in the semiconductor chip to the wiring board, and therefore, improves the heat dissipating property of the semiconductor chip. Furthermore, the bonding layer 2 is a sintered compact of a metal powder, and therefore, has high electrical conductivity. Therefore, if the semiconductor chip has a grounding terminal on a surface thereof facing the wiring board and the wiring board has grounding wiring at a position facing the grounding terminal, then the grounding terminal and the grounding wiring may be electrically connected to each other via the bonding layer 2.

If the base member 3 of the composite structure 1 is a wiring board and the element 4 to be bonded is a semiconductor chip, then the composite structure 1 is a semi-manufactured product of a semiconductor device 10, for example. In other words, the semiconductor device 10 may be fabricated based on the element 4 to be bonded. Next, an exemplary method for fabricating the semiconductor device 10 according to this embodiment will be described.

The method for fabricating the semiconductor device 10 includes the method for manufacturing the composite structure 1 described above. Specifically, first, the composite structure 1 is manufactured by the above-described method using a wiring board and a semiconductor chip as the base member 3 and the element 4 to be bonded, respectively.

Subsequently, the semiconductor chip and conductor wiring of the wiring board are electrically connected to each other. For this purpose, a wire bonding technique may be adopted, for example. Specifically, a terminal of the semiconductor chip and the conductor wiring of the wiring board are electrically connected to each other via a wire 6. Furthermore, an encapsulant 7 for encapsulating the semiconductor chip is formed as needed. The encapsulant 7 may be formed by, for example, molding and curing a thermosetting resin composition such as an epoxy resin composition around the semiconductor chip.

### Examples

Next, specific examples of this embodiment will be presented. Note that the specific examples to be described below are only examples of this embodiment and should not be construed as limiting.

### 1. Manufacturing composite structure

### (1) Preparing metal paste

A metal paste was prepared by mixing either silver powder and an organic component or silver powder, an organic component, and a silver salt together at any of the mass ratios shown in the following Table 1. Note that among the metal pastes shown in the following Table 1, compositions #3 and #6 were adopted in specific examples of the present disclosure and a comparative example, respectively, and the other compositions are shown as specific exemplary compositions of the metal paste.

**[Table 1]**

| | | | Composition | | | | | | | |
|---|---|---|---|---|---|---|---|---|---|---|
| Type | Manufacturer | Product number | 1 | 2 | 3 | 4 | 5 | 6 | 7 | 8 |
| Silver powder | Toyo Chemical Industries, Inc. | DJTA03N | 85 | 85 | 90 | 90 | 85 | 85 | 90 | 90 |
| Organic component | FUJIFILM Wako Pure Chemical Corporation | ethylhexanediol | 7.5 | 7.5 | 5 | 5 | 6.85 | 6.85 | 4.3 | 4.3 |
| | FUJIFILM Wako Pure Chemical Corporation | 2-ethylhexylamine | 7.5 | | 5 | | 6.85 | | | |
| | FUJIFILM Wako Pure Chemical Corporation | aminopropanol | | 7.5 | | 5 | | 6.85 | | 4.3 |
| Silver salt | FUJIFILM Wako Pure Chemical Corporation | silver acetate | | | | | 1.3 | 1.3 | 1.4 | 1.4 |

### (2) Application step

A direct bonded copper (DBC) board (manufactured by Hirai Seimitsu Kogyo Co., Ltd.) was provided as a base member. A metal paste having any of the compositions shown in the following Table 2 was applied by screen printing onto the surface of the base member. In this manner, a bonding material having planar dimensions of 10 mm × 10 mm and a thickness of 0.9 mm was provided.

### (3) Preheating step

In Examples 1-3, a base member provided with the bonding material was loaded into a dryer and heated to respective heating temperatures for respective heating durations shown in the following Table 2. On the other hand, in Examples 4-17 and Comparative Examples 1 and 2, the board provided with the bonding material was placed on a hot plate, thereby heating the bonding material to respective heating temperatures for respective heating durations shown in the following Table 2.

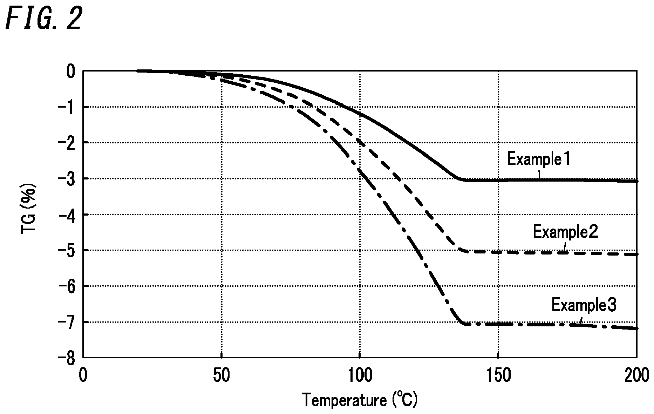

The bonding material thus heated was subjected to a thermogravimetric differential thermal analysis (TG-DTA). The content of an organic component in the bonding material was determined based on the result of the TG-DTA. The measurement was carried out using TG/DTA 7300 (manufactured by Hitachi High-Tech Corporation) in a nitrogen atmosphere under the condition including a temperature increase rate of 4°C/min. The results are summarized in the following Table 2. Also, the results of TG-DTA measurements with respect to Examples 1-3 are shown in FIG. 2.

### (4) Mounting step

A 2.5 mm square silver-plated Si chip (manufactured by Kyoto International, Inc.) was provided as an element to be bonded. While the bonding material was heated with the element to be bonded stacked, using a chip mounter, on the bonding material on the base member, load was applied to the element to be bonded toward the bonding material for 1 second. The pressures applied from the element to be bonded to the bonding material by applying the load to the element to be bonded and the heating temperatures of the bonding material are summarized in the following Table 2. Also, in Examples 13-17, ultrasonic vibrations were applied to the bonding material while the bonding material was heated with load applied to the element to be bonded toward the bonding material. The respective durations for which ultrasonic vibrations were applied are also shown in the following Table 2. In this manner, a multi-layer stack in which the base member, the bonding material, and the element to be bonded were stacked one on top of another in this order was formed.

### (5) Sintering step

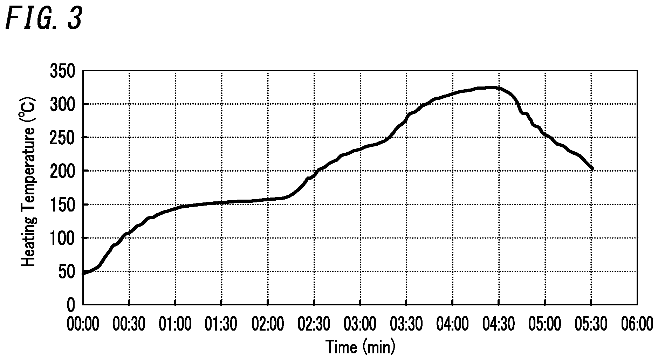

The multi-layer stack was heated in a reflow furnace under the following heating condition. Specifically, first, the heating temperature was increased from room temperature to 150°C at a temperature increase rate of about 1.5°C/s. Next, the heating temperature was maintained at 150°C for 60 seconds. Subsequently, the heating temperature was further increased to about 350°C at a temperature increase rate of about 1.5°C/s. Subsequently, the heating temperature was maintained at about 350°C for 30 seconds. Then, the multi-layer stack was cooled at a cooling rate equal to or higher than 10°C/s. The heating duration was about 6 minutes. FIG. 3 shows how the heating temperature varied with time in the sintering step in Example 1. In this manner, a bonding layer was formed by sintering the bonding material, thereby manufacturing a composite structure including the base member, the bonding layer, and the element to be bonded.

### 2. Evaluation tests

### (1) Void content percentage

Voids in the bonding layer were detected by ultrasonic testing. Based on the results of the testing, the volume percentage of voids in the bonding layer was determined. The results are summarized in the following Table 3.

### (2) Presence or absence of cracks

Ultrasonic testing was conducted to see if there were any cracks in the bonding layer. The results are also summarized in the following Table 3.

### (3) Bond strength

The bond strength between the element to be bonded (silver-plated Si chip) and the base member (silver-plated DBC board) was measured using a 4000 DAGE bond tester (manufactured by Nordson) under the following condition. Specifically, the test head was brought into contact with a side surface of the element to be bonded with the bottom of the test head located 50 µm over the surface of the base member and was moved at a velocity of 500 µm/sec toward the element to be bonded. The results are also summarized in the following Table 3.

### (4) Heat cycle test

The composite structure was repeatedly subjected to 1,000 heat cycles, in each of which the composite structure was exposed to an atmosphere at -40°C for 15 minutes and then exposed to an atmosphere at 150°C for 15 minutes. After having been subj ected to this test, the composite structure had its bonding state observed using an ultrasonic inspector FS300III advance (manufactured by Hitachi Power Solutions Co., Ltd.). If the bonding area of the composite structure did not change from its initial state, the composite structure was graded a "GO." On the other hand, if the bonding area thereof decreased from its initial state, the composite structure was graded a "NO-GO." The results are summarized in the following Table 3.

**[Table 2]**

| | Composition of Metal Paste Powder | Preheating Step | | | | Mounting Step | | |
|---|---|---|---|---|---|---|---|---|
| | | Device Used | Heating Temp.(°C) | Heating Duration(min) | Organic Component Content (mass%) After Heating | Pressure (MPa) | Heating Temp.(°C) | Ultrasonic Vibration Duration (s) |
| Ex.1 | Composition 3 | Dryer | 160 | 4 | 3.1 | 0.5 | 80 | - |
| Ex.2 | Composition 3 | Dryer | 160 | 2 | 5.2 | 0.5 | 80 | - |
| Ex.3 | Composition 3 | Dryer | 160 | 1 | 7.3 | 0.5 | 80 | - |
| Ex.4 | Composition 3 | Hot plate | 160 | 4 | 3.2 | 0.5 | 80 | - |
| Ex.5 | Composition 3 | Hot plate | 160 | 2 | 5.3 | 0.5 | 80 | - |
| Ex.6 | Composition 3 | Hot plate | 160 | 1 | 7.4 | 0.5 | 80 | - |
| Ex.7 | Composition 3 | Hot plate | 100 | 5 | 5.1 | 0.5 | 80 | - |
| Ex.8 | Composition 3 | Hot plate | 150 | 3 | 7.2 | 0.5 | 80 | - |
| Ex.9 | Composition 3 | Hot plate | 50 | 30 | 3 | 0.5 | 80 | - |
| Ex.10 | Composition 3 | Hot plate | 80 | 5 | 7.6 | 0.5 | 80 | - |
| Ex.11 | Composition 3 | Hot plate | 160 | 2 | 5.2 | 1 | 80 | - |
| Ex.12 | Composition 3 | Hot plate | 160 | 2 | 5.3 | 10 | 80 | - |
| Ex.13 | Composition 3 | Hot plate | 160 | 2 | 5.1 | 1 | 80 | 0.1 |
| Ex.14 | Composition 3 | Hot plate | 160 | 2 | 5.2 | 1 | 80 | 0.5 |
| Ex.15 | Composition 3 | Hot plate | 160 | 2 | 5.3 | 1 | 80 | 3 |
| Ex.16 | Composition 3 | Hot plate | 160 | 2 | 5.2 | 1 | 90 | 1 |
| Ex.17 | Composition 3 | Hot plate | 160 | 2 | 5.3 | 1 | 140 | 1 |
| Ex.18 | Composition 3 | Hot plate | 160 | 2 | 5.2 | 1 | 80 | 0.5 |
| Cmp.1 | Composition 3 | Hot plate | 160 | 6 | 2.5 | 0.5 | 80 | - |
| Cmp.2 | Composition 3 | Hot plate | 160 | 0.5 | 8.2 | 0.5 | 80 | - |

**[Table 3]**

| | Evaluation | | | |
|---|---|---|---|---|
| | Void Content Percentage (vol%) | Are cracks present or absent? | Bond Strength (MPa) | Heat Cycle Test |
| Ex.1 | 2 | Absent | 48 | GO |
| Ex.2 | 4 | Absent | 46 | GO |
| Ex.3 | 6 | Absent | 40 | GO |
| Ex.4 | 2 | Absent | 50 | GO |
| Ex.5 | 4 | Absent | 48 | GO |
| Ex.6 | 6 | Absent | 42 | GO |
| Ex.7 | 2 | Absent | 52 | GO |
| Ex. 8 | 6 | Absent | 44 | GO |
| Ex.9 | 6 | Absent | 46 | GO |
| Ex.10 | 6 | Absent | 44 | GO |
| Ex.11 | 4 | Absent | 48 | GO |
| Ex.12 | 4 | Absent | 50 | GO |
| Ex.13 | 4 | Absent | 52 | GO |
| Ex.14 | 4 | Absent | 55 | GO |
| Ex.15 | 4 | Absent | 57 | GO |
| Ex.16 | 3 | Absent | 58 | GO |
| Ex.17 | 3 | Absent | 60 | GO |
| Ex.18 | 4 | Absent | 62 | GO |
| Cmp. 1 | 1 | Absent | 17 | NO-GO |
| Cmp. 2 | 8 | Present | 38 | NO-GO |

## Claims

1. A method for manufacturing a composite structure, the composite structure including: a base member; an element to be bonded; and a bonding layer interposed between the base member and the element to be bonded,
the bonding layer being a sintered compact of a metal paste, the metal paste containing a metal powder and an organic component,
the method comprising:
an application step including providing a bonding material on the base member by applying the metal paste onto the base member;
a preheating step including heating the bonding material before the element to be bonded is stacked on the bonding material and thereby drying the bonding material until a percentage of the organic component in the bonding material becomes equal to or greater than 3% by mass and equal to or less than 8% by mass with respect to the bonding material;
a mounting step including stacking the element to be bonded onto the bonding material and heating the bonding material, on which the element to be bonded is stacked, to form a multi-layer stack including the base member, the bonding material, and the element to be bonded; and
a sintering step including sintering the bonding material by heating the multi-layer stack in a heating furnace and thereby forming the bonding layer.

2. The method of claim 1, wherein
the preheating step includes heating the bonding material by heating a surface of the bonding material, the surface being in contact with the base member.

3. The method of claim 1 or 2, wherein
the preheating step includes heating the bonding material to a heating temperature equal to or higher than 70°C and equal to or lower than 145°C.

4. The method of any one of claims 1 to 3, wherein
the preheating step includes heating the bonding material for a heating duration equal to or longer than 1 minute and equal to or shorter than 30 minutes.

5. The method of any one of claims 1 to 4, wherein
the mounting step includes applying load onto the element to be bonded toward the bonding material to apply a pressure equal to or higher than 0.5 MPa and equal to or lower than 10 MPa from the element to be bonded to the bonding material with the element to be bonded stacked on the bonding material.

6. The method of claim 5, wherein
the mounting step includes applying ultrasonic vibrations to the bonding material with the element to be bonded stacked on the bonding material.

7. The method of claim 6, wherein
the ultrasonic vibrations are applied to the bonding material for a duration equal to or longer than 0.5 seconds and equal to or shorter than 3 seconds.

8. The method of any one of claims 1 to 7, wherein
the mounting step includes heating the bonding material to a heating temperature equal to or higher than 70°C and equal to or lower than 145°C.

9. The method of any one of claims 1 to 8, wherein
in the composite structure, a bond strength between the base member and the element to be bonded is equal to or greater than 20 MPa and equal to or less than 60 MPa.

10. The method of any one of claims 1 to 9, wherein
the bonding layer has no voids, or
the bonding layer has voids, and a percentage of the voids is equal to or less than 7% by volume with respect to the bonding layer.

11. The method of any one of claims 1 to 10, wherein
the sintering step includes setting a highest heating temperature at a temperature equal to or lower than 350°C.

12. The method of any one of claims 1 to 11, wherein
the sintering step includes setting a heating duration at a duration equal to or longer than 3 minutes and equal to or shorter than 10 minutes.

13. The method of any one of claims 1 to 12, wherein
the base member is a wiring board, and
the element to be bonded is a semiconductor chip.

14. A method for fabricating a semiconductor device, the method including the method for manufacturing a composite structure according to claim 13.
